# FASCICULE DE BREVET EUROPEEN

(11) **EP 2 255 362 B1**
(45) Date de publication et mention de la délivrance du brevet: **09.05.2012**
(21) Numéro de dépôt: 09721466.2
(22) Date de dépôt: 17.03.2009
(51) Int. Cl.: G11C 11/16

(54) **ELEMENT MAGNETIQUE A ECRITURE ASSISTEE THERMIQUEMENT**
MAGNETELEMENT MT EINEM WÄRMEUNTERSTÜTZTEN SCHREIBVERFAHREN
MAGNETIC MEMBER WITH THERMALLY ASSISTED WRITING

(30) Priorité: 18.03.2008 FR 0851747
(43) Date de publication de la demande: 01.12.2010
(73) Titulaire: Crocus Technology S.A., 38025 Grenoble Cedex (FR)
(72) Inventeur: NOZIERES, Jean-Pierre, F-38700 Le Sappey en Chartreuse (FR); PREJBEANU, Ioan Lucian, F-38360 Sassenage (FR)
(74) Mandataire: P&TS SA (AG, Ltd.)
(86) Numéro de dépôt international: PCT/EP2009/053111
(87) Numéro de publication internationale: WO 2009/115505

(56) Documents cités:
- WO-A-2007/025050
- US-A1- 2005 254 287
- US-A1- 2006 120 126
- US-B1- 6 958 927

## Description

### Domaine technique

La présente invention se rattache au domaine des éléments magnétiques à jonction tunnel magnétique ou à vanne de spin, tels que ceux utilisés dans les mémoires magnétiques à accès aléatoire non volatiles, permettant, de manière connue, le stockage, la lecture et l'écriture de données dans les systèmes électroniques. Plus spécifiquement, elle s'applique aux mémoires magnétiques à accès aléatoire, désignées de manière traditionnelle sous l'acronyme MRAM, constituées d'un ensemble de points mémoire formés chacun par une jonction tunnel magnétique, également désignée sous l'acronyme JTM.

Dans ce qui suit, on entend donc par « élément magnétique » un empilement de couches magnétiques comportant au moins une couche dite « de référence », une couche dite « de stockage » et entre celles-ci une couche isolante ou semi-conductrice ou à chemins de courant confinés. La définition de la notion de couche de référence et de couche de stockage apparaîtra de manière plus précise dans la suite de la présente description.

### Etat de la technique

Les mémoires magnétiques MRAM ont connu un regain d'intérêt avec la mise au point de jonctions tunnel magnétiques présentant une forte magnétorésistance à température ambiante. Ces mémoires magnétiques à accès aléatoire présentent en effet de nombreux atouts :
- rapidité comparable à celle des SRAM,
- non volatilité, comme les mémoires flash,
- absence de fatigue à la lecture et à l'écriture,
- insensibilité aux radiations ionisantes.

Ce faisant, elles sont susceptibles de remplacer les mémoires de technologie plus traditionnelle (DRAM, SRAM, flash) et ainsi devenir une mémoire universelle.

Les premières architectures de mémoires magnétiques sont constituées d'un ensemble de points mémoire ou cellules mémoire, constitués chacun d'un élément dit « à magnétorésistance géante », constitué d'un empilement de plusieurs couches métalliques alternativement magnétiques et non magnétiques.

On a par exemple décrit ce type de structure dans les documents US4949039 et US5159513 pour les structures de base, et dans le document US5343422 pour la réalisation d'une mémoire RAM à partir de telles structures de base.

Cette technologie, de par son architecture, permet la réalisation de mémoires non volatiles avec une technologie simple, mais cependant de capacité limitée. En effet, le fait que les éléments mémoire ou points mémoire soient connectés en série le long de chaque ligne, limite la possibilité d'intégration, puisque le signal est de plus en plus faible lorsque le nombre d'éléments ou points mémoire augmente.

La mise au point des points mémoire à jonction tunnel magnétique a permis l'augmentation significative des performances et du mode de fonctionnement de ces mémoires. De telles mémoires magnétiques à jonction tunnel magnétique ont par exemple été décrites dans le document US5640343. Dans leurs formes les plus simples, elles sont composées de deux couches magnétiques de champs de retournements différents, découplées magnétiquement par une couche mince isolante, appelée barrière tunnel. Lorsque les aimantations des couches respectives de stockage et de référence, constituant les deux couches magnétiques précitées, situées de part et d'autre de la barrière tunnel, sont antiparallèles, la résistance de la jonction tunnel magnétique est élevée. A l'inverse, lorsque les aimantations sont parallèles, cette résistance devient faible.

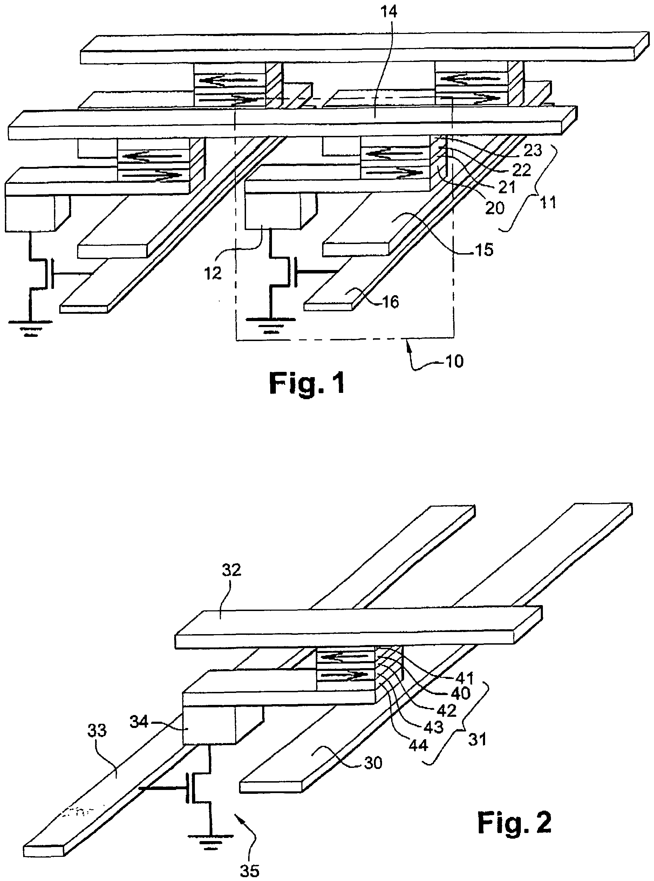

L'architecture la plus classique dite « FIMS », acronyme de l'expression anglo-saxonne « Field Induced Magnetic Switching », c'est-à-dire le renversement de l'aimantation par un champ magnétique externe, créé par des lignes de courant ou conducteurs associés à chacun desdits points magnétiques est celle décrite dans le document US6021065 et dans la publication "Journal of Applied Physics" vol. 81, 1997, page 3758 et représentée sur la figure 1.

Chaque élément mémoire ou point mémoire 10 est constitué de l'association d'un transistor de technologie CMOS 12 et d'une jonction tunnel magnétique JTM 11. Ladite jonction tunnel 11 comporte au moins une couche magnétique 20, appelée « couche de stockage », une fine couche isolante 21, et une couche magnétique 22 dite « couche de référence ».

De manière préférentielle, les deux couches magnétiques 20 et 21 sont réalisées à base de métaux 3d (Fe, Co, Ni) et leurs alliages (susceptibles de contenir du bore ou du zirconium de telle sorte à rendre amorphe la structure desdites couches et d'aplatir leurs interfaces), et la couche isolante 21 est traditionnellement constituée d'alumine amorphe (AlOx) ou d'oxyde de magnésium cristallin ou texturé (MgO).

Avantageusement, la couche de référence, peut elle-même être constituée d'un empilement de plusieurs couches, tel que par exemple décrit dans le document US5583725 et ce, afin de constituer une couche dite « antiferromagnétique synthétique » (SAF). De même, il est possible de remplacer, pour chacun des points mémoire, la jonction tunnel magnétique unique par une double jonction tunnel magnétique, tel que par exemple décrit dans la publication Y. Saito & al, Journal of Magnetism and Magnetic Materials », Volume 223, 2001, page 293. Dans ce cas, la couche de stockage est interposée entre deux couches isolantes, la structure comportant deux couches de référence positionnées sur les faces opposées auxdites couches isolantes respectives.

Les impulsions de champ magnétique produites en faisant circuler dans les lignes de courant 14 et 15 des impulsions électriques courtes, typiquement 2 à 50 nanosecondes, et d'intensité de l'ordre de plusieurs milliampères assurent la sélectivité à l'écriture du point mémoire localisé à l'intersection de ces lignes de courant. En effet, l'intensité de ces impulsions et leur synchronisation sont ajustées, de sorte que seule l'aimantation du point mémoire situé à l'intersection de ces deux lignes de courant soit susceptible de commuter.

De par le mécanisme d'écriture de ces points mémoire, on est à même de comprendre les limites de cette architecture :
- dans la mesure où l'écriture est assurée par un champ magnétique extérieur, elle est assujettie à la valeur du champ de retournement individuel de chaque point mémoire. Comme la fonction de distribution des champs de retournement pour l'ensemble des points mémoire est large (en effet, elle n'est pas uniforme en raison des contraintes de fabrication et des fluctuations statistiques intrinsèques), il est nécessaire que le champ magnétique sur le point mémoire sélectionné soit supérieur au champ de retournement le plus élevé de la distribution, au risque de renverser accidentellement certains points mémoire situés sur la ligne ou sur la colonne correspondante, où le champ de retournement situé dans la partie basse de la distribution est plus faible que le champ magnétique généré par la ligne ou la colonne seule.
- de plus, attendu qu'en général, la valeur moyenne du champ de retournement augmente lorsque la taille des points mémoire diminue, ce que l'on tend à obtenir pour des raisons d'encombrement et de coût, un courant d'autant plus important est attendu dans les générations de produits futurs. En conséquence, la puissance électrique requise pour le fonctionnement de ces mémoires sera d'autant plus grande que l'intégration sera poussée.
- enfin, la stabilité de l'aimantation de la couche libre vis-à-vis des fluctuations thermiques n'est plus assurée lorsque la taille du point mémoire diminue. En effet, la barrière d'énergie à franchir pour faire commuter l'aimantation de cette couche d'une orientation à l'autre est proportionnelle au volume de cette couche. Lorsque le volume diminue, la hauteur de la barrière devient alors comparable à l'agitation thermique. L'information écrite dans la mémoire n'est alors plus conservée. Pour pallier cette difficulté, on est obligé d'augmenter l'anisotropie magnétique de la couche libre en choisissant un matériau de plus forte anisotropie ou en accentuant l'anisotropie de forme du point mémoire, par exemple. Mais ce faisant, le champ magnétique nécessaire à la commutation magnétique augmente, résultant en une consommation électrique accrue pour générer le champ nécessaire à la commutation magnétique.

Aussi, afin de surmonter cette difficulté, nous avons proposé la mise en oeuvre de mémoires magnétiques à accès aléatoire à écriture assistée thermiquement, dénommées selon l'acronyme « TA-MRAM ». La particularité de l'empilement du point mémoire de cette architecture est le piégeage de la couche de stockage par une couche antiferromagnétique de température de blocage inférieure à la celle de la deuxième couche antiferromagnétique piégeant la couche de référence. Cette technique est par exemple décrite dans le document US6385082.

Dans cette configuration, la sélectivité à l'écriture est réalisée par une élévation de température courte du point mémoire à adresser, réalisée par une impulsion de courant traversant ledit point mémoire considéré. Pour écrire le point, cette élévation de température est alors combinée soit à une impulsion de champ magnétique, soit au phénomène de transfert de spin obtenu par l'injection d'un courant polarisé en spin à travers la couche de stockage dudit point mémoire.

L'empilement type d'un point mémoire caractéristique pour l'architecture de mémoires magnétiques à écriture assistée thermiquement TA-MRAM est représenté au sein de la figure 2. Dans cet empilement de la jonction tunnel magnétique 31, la couche de stockage 40 est piégée par une couche antiferromagnétique 41. De même que dans le cas des mémoires FIMS, une couche isolante 42 est comprise entre la couche de stockage 40 et la couche de référence 43. Selon cette configuration, les deux couches magnétiques sont avantageusement réalisées en des métaux de transition 3d (Fe, Co, Ni) et leurs alliages, préférentiellement dopées (avec de bore ou du zirconium notamment), et la couche isolante peut être de l'alumine ou de l'oxyde de magnésium. Selon une version avantageuse, la couche magnétique de référence 43 est couplée à une couche antiferromagnétique 44, dont la fonction est de bloquer la couche 43 afin que son aimantation ne bascule pas lors de l'écriture. La température de blocage de la couche antiferromagnétique 44 piégeant la couche de référence 43 est largement supérieure à la température de blocage de la couche antiferromagnétique 41 piégeant la couche de stockage 40.

Là encore, la couche magnétique de référence 43 peut être une couche antiferromagnétique synthétique constituée de plusieurs couches.

Selon cette configuration, la couche antiferromagnétique 41 possède une température limite dite « de blocage » TB au dessus de laquelle le champ magnétique dit « d'échange » stabilisant qu'elle exerce sur la couche libre 40 n'est plus effectif sur la couche de stockage 40. On sélectionne le matériau constituant la couche antiferromagnétique 41 ainsi que son épaisseur, de telle sorte que la température de blocage TB soit supérieure à la température d'utilisation de la mémoire (température de fonctionnement au repos). De la même manière, on sélectionne la température de blocage TB de la couche antiferromagnétique 44 adjacente à la couche piégée 43 afin qu'elle soit supérieure et assez éloignée de la température de blocage de la couche antiferromagnétique 41.

Cette architecture particulière comporte deux ou trois niveaux de ligne de courant suivant que la commutation est réalisée par transfert de spin ou par champ magnétique. Tout d'abord, pour l'écriture par champ magnétique, une ligne de courant 30 dite « ligne de champ », est située sous la jonction tunnel magnétique 31 sans être en contact avec cette dernière. Cette ligne est destinée à générer le champ magnétique nécessaire au renversement de la couche de stockage 40, dès lors qu'un courant électrique de plusieurs milliampères la traverse et génère un échauffement dépassant la température de blocage de la couche antiferromagnétique 41 piégeant la couche de stockage 40. Cette ligne n'existe pas lorsque la commutation est réalisée par injection de courant polarisé en spin. Deuxièmement, une autre ligne de courant 32 dite « Bit line », est située au-dessus de la jonction tunnel magnétique 31 du point mémoire considéré et en contact avec celle-ci. Enfin, une troisième ligne de courant 33 dite « Word line » est en contact, par l'intermédiaire d'un via 34, avec un transistor CMOS 35, dont la « word line » constitue la grille. De même que pour l'architecture FIMS, dans une architecture TA-MRAM la « word line » commande l'ouverture ou la fermeture du canal des transistors sur toute sa longueur par l'application ou non d'une tension seuil, chacun des transistors fonctionnant en mode interrupteur pour chacun des points mémoire associés.

En mode écriture, le transistor CMOS 35 du point mémoire à écrire est fermé par l'application d'une tension adéquate dans la « word line » 33. Un courant de chauffage est alors envoyé dans le point mémoire à écrire par la « bit line » 32. A partir d'une certaine densité de courant, celui-ci induit l'élévation de température de la jonction tunnel magnétique 31 au dessus de la température de blocage de la couche antiferromagnétique 41. Le champ d'échange stabilisant la couche libre 40 devient alors nul, et ladite couche de stockage peut être écrite à des champs très réduits. Pour écrire la couche de stockage 40, une impulsion électrique est alors envoyée dans la ligne de champ 30 une fois que la température de blocage est atteinte (au bout de quelques nanosecondes). Cette impulsion génère un champ magnétique suffisant pour retourner l'aimantation de la couche de stockage 40 dans le sens souhaité (écriture du bit "1 " ou "0"). Pour une commutation par injection de courant polarisé en spin, on se sert du courant de chauffage à la fois pour chauffer la couche de stockage du point mémoire et pour appliquer un couple de transfert de spin sur l'aimantation de cette couche. Pour ce faire, le flux d'électrons du courant de chauffage doit être polarisé en spin, ce qui est généralement réalisé en le faisant traverser une couche magnétique additionnelle appelée couche de polarisation - dans le cas de l'empilement de la figure 2 ce rôle est joué par la couche de référence. Une fois que la couche de stockage 40 a été écrite, on coupe alors le courant de chauffage dans la jonction tunnel magnétique 31 (par coupure du courant dans la « bit line » 32 et ouverture du transistor 35). La température globale du point mémoire chute alors très rapidement (quelques nanosecondes) en deçà de la température de blocage de la couche antiferromagnétique 41 (à la température de fonctionnement au repos typiquement), et le champ d'échange reprend alors sa valeur initiale mais dans le sens opposé, stabilisant à nouveau la couche de stockage 40.

De telles mémoires magnétiques à écriture assistée thermiquement présentent un certain nombre d'avantages, parmi lesquels on peut citer :
- une amélioration significative dans la sélectivité à l'écriture du fait que seul le point mémoire à écrire est chauffé ;
- la conservation de l'information écrite dans la mémoire même lorsque le point mémoire est exposé à des champs magnétiques parasites à température ambiante ;
- une amélioration de la stabilité thermique de l'information par la mise en oeuvre de matériaux avec une forte anisotropie magnétique à température ambiante (intrinsèque ou due au champ d'anisotropie d'échange de la couche antiferromagnétique piégeant la couche de stockage 40);
- la possibilité de réduire de manière significative la taille des cellules des points mémoire sans affecter leur limite de stabilité de par l'utilisation de matériaux avec une forte anisotropie magnétique à température ambiante ou à couche de stockage piégée par anisotropie d'échange;
- une réduction de la consommation lors de l'écriture ;
- la possibilité d'obtenir des cellules de stockage multi-niveaux dans certaines circonstances.

Nonobstant ces avantages, on se heurte cependant, à certaines difficultés sur le plan de la technologie de fabrication.

La principale de ces difficultés est liée à la nécessité d'appliquer une impulsion de courant à travers la jonction tunnel magnétique afin de chauffer le point mémoire à une température supérieure à la température de blocage de la couche antiferromagnétique piégeant la couche de stockage. Cette impulsion de courant est susceptible de soumettre la couche d'oxyde ultramince, constitutive de la barrière tunnel, à un stress électrique important. En effet, la tension associée pourrait approcher, voire dépasser dans des systèmes non adaptés du point de vue du confinement thermique la tension de claquage d'une telle couche d'oxyde, se situant typiquement autour de 1 Volt. En outre, même si la tension appliquée sur la barrière tunnel est inférieure à sa tension de claquage, le stress lié à l'impulsion de courant électrique peut aboutir à des effets de vieillissement importants à longue échéance, notamment après un grand nombre de cycles d'écriture.

Le document US2006120126 divulgue une jonction magnétique comportant une première et une seconde couche ferromagnétique ayant chacune une magnétisation piégée dans une direction essentiellement opposée, et une troisième couche ferromagnétique libre, disposée entre les première et seconde couches. La jonction comporte également deux couches intermédiaires résistives, l'une entre la première et troisième couche ferromagnétique, et l'autre entre et la seconde et la troisième couche ferromagnétique. La présence des couches intermédiaires permet d'abaisser la magnitude du courant critique requis pour le renversement du champ magnétique de la couche ferromagnétique libre.

Dans le document US2005254287, une jonction magnétique comporte une couche ferromagnétique bloquée et une couche ferromagnétique libre écrite par transfert de spin, les deux couches étant séparées par une couche à chemin de courant confiné. La jonction comporte également une couche additionnelle de barrière de spin et/ou une couche d'accumulation de spin, la couche libre étant disposée entre la couche à chemin de courant confiné et la couche de barrière de spin et la couche additionnelle. Cette dernière permet d'augmenter l'efficacité de l'injection de spin lors du renversement de l'aimantation par transfert de spin.

Un courant de spin plus faible pour le renversement de l'aimantation est également obtenu avec la jonction décrite dans le document WO2007025050 et comportant une couche isolante, placée entre une couche ferromagnétique piégée et une couche ferromagnétique libre, ainsi qu'une couche d'accumulation de spin, placée adjacente à la couche libre et permettant une magnétorésistance plus élevée de la jonction.

Similairement, la jonction magnétique décrite dans le document US6958927 permet d'utiliser un courant de spin plus faible pour l'écriture de la couche ferromagnétique libre grâce à la présence d'une couche de demi-métal en surface de la couche de référence.

Afin de simultanément préserver un courant suffisant important injecté à travers le point mémoire tout en minimisant la tension aux bornes de la couche d'oxyde constituant la barrière tunnel, il a été proposé par le passé la mise en oeuvre d'une double jonction tunnel, c'est-à-dire de deux jonctions tunnel magnétiques, séparées l'une de l'autre par une couche métallique, telle que par exemple décrite dans le document US6950335. Ce faisant, pour la même densité de puissance, qui constitue le paramètre critique de l'échauffement du point mémoire, on aboutit à une diminution importante de la tension aux bornes de chacune des barrières tunnel. Cependant, cette double jonction tunnel magnétique présente une complexité accrue en termes de réalisation de l'empilement et de réalisation des cellules mémoire, notamment durant la phase de gravure du point mémoire.

Au surplus, l'utilisation d'une double jonction tunnel magnétique présente des inconvénients pour une architecture à écriture basée sur le transfert de spin. En effet, si les aimantations des deux couches magnétiques de référence sont bloquées antiparallèlement, l'efficacité du couple de spin est importante, mais la valeur des résistances des deux états mémoire devient comparable et subséquemment, la marge de lecture s'en trouve drastiquement réduite.

Alternativement, si les aimantations des deux couches magnétiques de référence sont bloquées parallèlement, la marge de lecture est importante mais l'efficacité du couple de spin est significativement réduite dans la mesure où les deux contributions pour les deux couches de référence se soustraient l'une de l'autre.

### Bref résumé de l'invention

L'objectif de la présente invention est de proposer un système innovant permettant de simultanément préserver un courant suffisant important injecté à travers le point mémoire tout en minimisant le plus possible la tension aux bornes de la couche d'oxyde ultramince constituant la barrière tunnel ultramince. Ceci permettra d'obtenir à la fois un couple de spin et/ou un échauffement suffisamment efficaces pour l'écriture du point mémoire et de minimiser les risques de claquage et de vieillissement de la barrière tunnel.

Un autre objectif visé par la présente invention est de minimiser la tension à travers la couche mince d'oxyde, constitutive de la barrière tunnel, pour une densité de courant déterminée, c'est-à-dire pour une amplitude de chauffage et/ou un couple de spin donné tout en conservant le même niveau de marge de lecture en termes de résistance ou magnétorésistance.

A cet effet, l'invention vise un élément magnétique à écriture par champ magnétique ou par transfert de spin, assistés thermiquement selon la revendication 1.

Ici, une couche mince de forte résistivité électrique signifie, comme cela est normalement compris par l'homme de métier, une couche dont la résistivité est sensiblement supérieure aux couches magnétiques de l'élément magnétique, telles que, par exemple, la couche magnétique de stockage ou couche magnétique de référence.

La mise en oeuvre de telles couches à forte résistivité électrique d'épaisseur très réduite, et notamment de l'ordre voire inférieur au nanomètre, permet d'optimiser la résistance de l'empilement de la jonction tunnel magnétique sans pour autant affecter la résistance propre de la couche constitutive de la barrière tunnel interposée entre la couche de stockage et la couche de référence.

Typiquement, et selon l'invention, cette ou ces couches minces à forte résistivité électrique sont réalisées en oxydes ou nitrures métalliques, le métal étant choisi dans le groupe comprenant le tantale, l'aluminium, le cobalt, le zirconium, le zinc et le magnésium.

Ces couches d'oxyde ou de nitrure peuvent être obtenues par dépôt de couches métalliques ultraminces, typiquement d'une épaisseur inférieure à la monocouche, notamment par pulvérisation cathodique (également connue sous l'expression anglo-saxonne « sputtering »). Ces couches métalliques peuvent être oxydées de manière subséquente, par oxydation naturelle ou par plasma ou nitrurées par un dépôt dans une atmosphère partielle d'azote.

L'épaisseur de ces couches d'oxyde ou de nitrure est préférentiellement inférieure au nanomètre afin d'obtenir des couches préférentiellement discontinues, permettant de conserver la continuité des propriétés magnétiques des couches ferromagnétiques ou antiferromagnétiques au niveau desquelles elles sont rapportées.

Avantagesement, toute ou partie des couches magnétiques entrant dans la constitution de la ou desdites bicouches de la couche de stockage comprend une couche mince d'oxyde ou de nitrure métallique.

Cette solution présente notamment l'avantage par rapport à l'art antérieur un gain en tension typiquement de 10% à 50% lorsqu'une ou plusieurs couches minces à forte résistivité sont introduites dans la jonction magnétique. Ceci résulte en une diminution du stress induit lors de l'opération s'écriture, ainsi qu'une diminution des effets de vieillissement de la jonction. La présence d'une ou plusieurs couches minces dans l'élément magnétique de l'invention permet également de chauffer plus efficacement la jonction magnétique.

### Brève description des figures

La manière dont l'invention peut être réalisée et les avantages qui en découlent ressortiront mieux de l'exemple de réalisation qui suit, donné à titre indicatif et non limitatif à l'appui des figures annexées où :
la figure 1 déjà décrite est une représentation schématique de l'architecture d'une mémoire magnétique de type FIMS de l'état antérieur de la technique ;
la figure 2, également déjà décrite, est une représentation schématique d'une mémoire magnétique mettant en oeuvre une mémoire MRAM à écriture assistée thermiquement, également connue de l'état antérieur de la technique ;
la figure 3 est une représentation schématique d'un point mémoire mis en oeuvre dans le cadre d'une mémoire magnétique à écriture assistée thermiquement de la figure 2 ; et
la figure 4 est une représentation de détail de la couche de stockage du point mémoire de la figure 3.

### Exemple(s) de mode de réalisation de l'invention

On a abondamment décrit dans le préambule de la présente invention l'état antérieur de la technique relatif aux mémoires magnétiques à accès aléatoire.

Ce faisant, et dans l'objectif de simplifier la présente description, seul un point mémoire constitutif de telles mémoires magnétiques va être décrit ci-après plus en détail.

Comme déjà dit, celui-ci est fondamentalement constitué d'un élément magnétique magnétorésistif, préférentiellement une jonction tunnel magnétique 31. Celle-ci comporte une barrière tunnel 42, sélectionnée dans le groupe comprenant entre autres les oxydes d'aluminium Al2O3 et de magnésium MgO.

Alternativement, la couche 42 séparant la couche de référence 43 de la couche de stockage 40 peut être de nature semi-conductrice (par exemple à base de silicium ou de germanium ou en GaAs) ou d'une couche métal/oxyde hétérogène, comme les couches à chemin de courant confiné, selon l'expression anglo-saxonne « Current Confined Path » développées dans le contexte des têtes de lecture magnétorésistives pour disque dur. Ces dernières sont par exemple constituées d'alliages Al1-xCux avec x compris entre 0,5 et 10 % atomique, que l'on oxyde, formant une couche d'alumine amorphe, percée de trous métalliques de cuivre.

Dans l'objectif visé par la présente invention, si l'on ne souhaite pas affecter la résistance propre de la barrière tunnel 42, en revanche, on vise à augmenter la résistance de la couche de stockage et/ou de la couche de référence.

Pour ce faire, et selon l'invention, on dépose au sein et / ou à la surface de la couche ferromagnétique 43 constitutive de la couche de référence, et/ou de la couche ferromagnétique 40 constitutive de la couche de stockage, voire à l'interface entre les couches 40 et 43 avec les couches antiferromagnétiques 41 et 44 auxquelles elles sont respectivement couplées, une très fine couche 48 d'un oxyde ou de nitrure métallique, typiquement mais de manière non limitative constitué d'oxyde (nitrure) de tantale, d'aluminium, de cobalt, de zirconium, de zinc ou de magnésium.

Cette couche 48 présente préférentiellement une épaisseur subnanométrique, c'est-à-dire au maximum égale à 1 nanomètre, de telle sorte à ne pas affecter les propriétés magnétiques de la couche magnétique à laquelle elle est associée.

Ce dépôt peut être réalisé par pulvérisation cathodique d'une couche subnanométrique de métal qui est oxydée de manière subséquente par oxydation naturelle ou par plasma. Alternativement, la couche métallique peut être nitrurée par dépôt de la couche métallique dans une atmosphère partielle d'azote. Alternativement, l'oxyde peut être déposé directement par pulvérisation dans un plasma réactif.

Dans un mode de réalisation de l'invention, au moins une couche mince 48 à forte résistivité électrique est déposée sur l'une des faces de la couche ferromagnétique 43 constitutive de la couche de référence, et/ou de la couche ferromagnétique 40 constitutive de la couche de stockage. Par exemple, dans le cas de la jonction 31 comportant une couche antiferromagnétique 41 piégeant la couche de stockage 40 et une couche antiferromagnétique 44 piégeant la couche de référence 43, la couche mince 48 est déposée à l'interface entre la couche de stockage 40 et antiferromagnétique 41 et/ou à l'interface entre la couche de référence 43 et antiferromagnétique 44.

Dans un mode préféré de réalisation de l'invention, la ou les couches minces 48 sont déposées au sein de la couche ferromagnétique 43 constitutive de la couche de référence, et/ou de la couche ferromagnétique 40 constitutive de la couche de stockage.

Dans un autre mode de réalisation de l'invention, ces couches minces 48 sont introduites dans la couche antiferromagnétique d'échange 44 piégeant la couche de référence ou dans la couche antiferromagnétique d'échange 41 piégeant la couche de stockage.

Le placement de la ou des couches minces résistives 48 au sein de la couche ferromagnétique 40, ou encore dans la couche antiferromagnétique d'échange 41, est avantageux puisqu'il favorise l'élévation de température à proximité de la couche ferromagnétique 40 qui doit être chauffée au-delà de sa température de blocage.

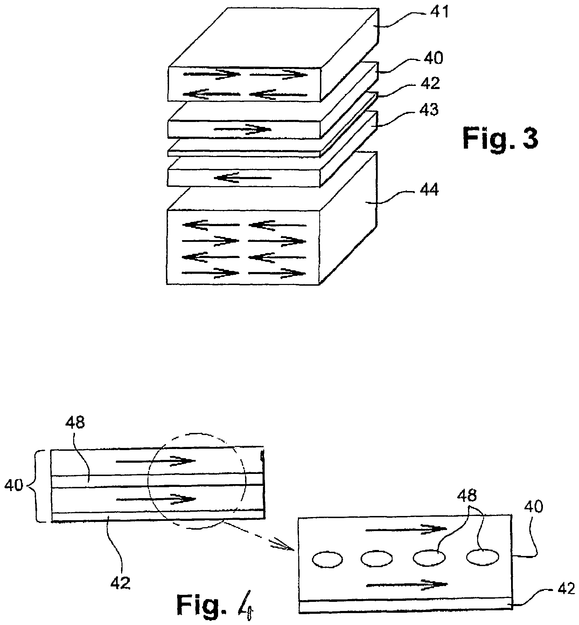

La ou les couches d'oxyde métallique 48 ainsi réalisées sont avantageusement discontinues, ainsi qu'illustré sur la figure 4, pour justement garantir la continuité des propriétés magnétiques des couches ferromagnétiques ou antiferromagnétiques dans lesquelles, sur lesquelles ou à l'interface desquelles elles sont déposées.

De par la mise en oeuvre de telles couches d'oxyde ou de nitrure métallique, on augmente la résistance totale de l'empilement sans affecter la résistance propre de la barrière tunnel 42. Ce faisant, on augmente l'efficacité de chauffage, notamment lors de la phase d'écriture, dans la mesure où celui-ci est proportionnel à l'expression RI², dans laquelle R représente la somme de la résistance de la barrière tunnel R_{MTJ} et de la résistance de la couche d'oxyde ou de nitrure métallique ainsi déposée R_{NOL}. Corollairement, la tension correspondante V_{MTJ} diminue au niveau de la barrière tunnel en raison de l'introduction de ces résistances additionnelles.

Ainsi, considérant une densité de puissance constante on a les expressions :

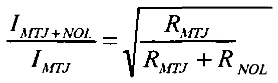

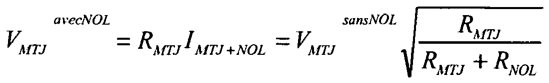

où V_{MTJ} ^{avecNOL} désigne la tension aux bornes de la jonction tunnel magnétique 31 intégrant une ou plusieurs couches d'oxyde métallique (NOL pour Nano Oxyde Layer) et où V_{MTJ}^{sansNOL} désigne la tension aux bornes de la jonction tunnel magnétique en l'absence de telles couches.

Typiquement, la résistance des couches d'oxyde métallique à base d'aluminium ou de tantale est comprise entre 0,5 et 5 Ω/µm² dépendant de l'épaisseur et des conditions de réalisation.

Si l'on considère un produit résistance fois la surface de la couche d'oxyde métallique de 5Ω/µm², et de la jonction tunnel de 50 Ω/µm², le gain en tension est d'environ 5 % pour chacune des couches d'oxyde métallique introduites dans la structure.

Si l'on met en oeuvre une structure à empilement multiple au niveau de la couche de stockage dans laquelle plusieurs couches d'oxyde métallique sont introduites conformément à l'invention, l'importance de la diminution du stress électrique peut atteindre 30 %.

Pour un produit RA voisin de 20 Ω/µm², le gain en tension peut même être supérieur, typiquement 10 % pour une seule couche d'oxyde métallique à 50 % pour l'introduction d'une telle couche d'oxyde métallique dans une couche de stockage constituée de 10 bicouches (couche magnétique + couche amorphe).

Les mémoires magnétiques MRAM ainsi obtenues présentent une endurance fortement améliorée dans la mesure où le stress induit par la phase d'écriture est fortement réduit, et où la tension appliquée à la jonction tunnel magnétique lors de la phase de lecture est faible, typiquement inférieure à 200 mV.

Dans le cas de la configuration des mémoires magnétiques à écriture assistée thermiquement (TA-MRAM), et plus particulièrement dans le cadre des mémoires magnétiques à écriture par injection de courant polarisée en spin assistée thermiquement TA-STT-MRAM, essentielles pour aboutir à des caractéristiques dimensionnelles inférieures ou égales à 90 nanomètres, un courant important doit traverser ladite jonction tunnel magnétique. La solution proposée par l'invention mettant en oeuvre des couches d'oxyde ou de nitrure métallique a pour effet de diminuer la tension au niveau de la jonction tunnel, permettant ainsi la mise en oeuvre de cette configuration plus facilement.

On conçoit de fait tout l'intérêt de la présente invention pour la réalisation de mémoires magnétiques mettant en oeuvre de tels éléments mémoires, notamment dans le cadre de l'optimisation du nombre de cycles de lecture et d'écriture, et la réduction de courant nécessaire à l'écriture.

### Numéros de référence employés sur les figures

- 11: jonction tunnel magnétique
- 14: lignes de courant
- 15: lignes de courant
- 20: couche de stockage
- 21: couche isolante
- 22: couche de référence
- 30: ligne de courant (ligne de champ)
- 31: jonction tunnel magnétique
- 32: autre ligne de courant (Bit line)
- 33: troisième ligne de courant (Word line)
- 34: via
- 35: transistor CMOS
- 40: couche de stockage
- 41: couche antiferromagnétique
- 42: couche isolante (barrière tunnel)
- 43: couche de référence (couche ferromagnétique)
- 44: couche antiferromagnétique
- 48: fine couche (couche mince)

- R_{MTJ}: résistance de la barrière tunnel
- R_{NOL}: résistance de la couche mince
- I_{MTJ}: courant déterminé constant passant dans la jonction
- V_{MTJ}: tension aux bornes de la jonction
- V_{MTJ}^{avecNOL}: tension aux bornes de la jonction intégrant une ou plusieurs couches minces
- V_{MTJ}^{sansNOL}: tension aux bornes de la jonction en l'absence de telles couches

## Revendications

1. Elément magnétique à écriture par champ magnétique assisté thermiquement ou par transfert de spin assistée thermiquement comportant :
• une couche magnétique de référence (43), dont l'aimantation est de direction fixe ;
• une couche magnétique de stockage (40), piégée par échange avec une couche antiferromagnétique (41); la direction de l'aimantation de la couche de stockage (40) étant capable de varier lorsque ledit élément est apte à chauffer à une température au moins supérieure à la température de blocage de la couche antiferromagnétique (41) ;
• une couche isolante ou semi-conductrice (42), ou une couche à chemin de courant confiné, interposée entre la couche de référence et la couche de stockage ;
**caractérisé en ce que**
l'élément magnétique comprend également au moins une couche mince (48) électriquement résistive déposée au sein d'au moins l'une des couches comprenant la couche magnétique de référence (43), la couche magnétique de stockage (40), la couche antiferromagnétique d'échange (41), et/ou déposée à l'interface entre la couche de stockage (40) et la couche antiferromagnétique (41), ladite au moins une couche mince (48) électriquement résistive permettant de chauffer l'élément magnétique.

2. L'élément magnétique selon la revendication 1, dans laquelle la couche magnétique de référence (43) est couplée à une couche antiférromagnétique (44) et dans laquelle
ladite au moins une couche mince (48) est comprise au sein de la couche antiférromagnétique (44) et/ou à l'interface entre la couche de référence (43) et la couche antiferromagnétique (44).

3. Elément magnétique à écriture par champ magnétique ou assisté thermiquement ou par transfert de spin assisté thermiquement selon les revendications 1 ou 2, **caractérisé en ce que** la ou des couches minces (48) ont une résistivité électrique d'environ dix fois inférieure à la résistance propre de la barrière tunnel (42).

4. Elément magnétique à écriture par champ magnétique ou assisté thermiquement ou par transfert de spin assisté thermiquement selon l'une des revendications 1 à 3, **caractérisé en ce que** l'épaisseur de la ou des couches minces (48) est au plus égale à un nanomètre.

5. Elément magnétique à écriture par champ magnétique ou par transfert de spin assisté thermiquement selon l'une des revendications 1 à 4, **caractérisé en ce que** la ou les couches (48) de forte résistivité électrique sont discontinues.

6. Elément magnétique à écriture par champ magnétique ou par transfert de spin assisté thermiquement selon l'une des revendications 1 à 5, **caractérisé en ce que** la ou les couches (48) de forte résistivité électrique sont réalisées en oxyde métallique ou en nitrure métallique.

7. Elément magnétique à écriture par champ magnétique ou par transfert de spin assisté thermiquement selon la revendication 6, **caractérisé en ce que** le métal entrant dans la composition de l'oxyde ou du nitrure métallique constitutif de la ou des couches (48) est choisi dans le groupe comprenant le tantale, l'aluminium, le magnésium, le zirconium, le zinc et le cobalt.

## Claims

1. Magnetic element with thermally-assisted magnetic-field writing or thermally-assisted spin-transfer writing, each including:
• a reference magnetic layer (43) having a fixed direction magnetization;
• a storage magnetic layer (40) exchange-trapped with an antiferromagnetic layer (41), wherein the magnetization direction of the storage layer (40) can vary when said element can be heated to a temperature at least higher than the blocking temperature of the antiferromagnetic layer (41);
• an insulation or semiconducting layer (42) or a layer having a confined current path, provided between the reference layer and the storage layer;
**characterized in that**
the magnetic element comprises as well at least a thin layer (48) electrically-resistive in at least of one of the layers comprising the magnetic reference layer (43), the magnetic storage layer (40), the antiferromagnetic exchange-layer (41), und/or an interface between the storage layer (40) and the antiferromagnetic layer (41), said at least one electrically-resistive thin layer (48) allows to heat the magnetic member.

2. The magnetic element according to claim 1, wherein said magnetic reference layer (43) is coupled to an antiferromagnetic layer (44) and wherein said at least one thin layer (48) is comprised in the antiferromagnetic layer (44) and/or in the interface between the reference layer (43) und the antiferromagnetic layer (44).

3. Magnetic element with magnetic field writing or thermally-assisted writing or thermally-assisted spin-transfer writing according to the claims 1 or 2, **characterized in that** the thin layer or layers (48) have a electric resistivity of about 10 times lower than the internal resistance of the tunnel barrier (42).

4. Magnetic element with magnetic field writing or thermally-assisted writing or thermally-assisted spin-transfer writing according to one of the claims 1 to 3, **characterized in that** the thickness of the thin layer or layers (48) is at most equal to one nanometer.

5. Magnetic element with thermally-assisted magnetic field or spin-transfer writing according to one of the claims 1 to 4, **characterized in that** the layer or layers (48) with high electric resistivity are discontinuous.

6. Magnetic element with thermally-assisted magnetic field or spin-transfer writing according to one of the claims 1 to 5, **characterized in that** the layer or layers (48) with high electric resistivity are made of metal oxide or metal nitride.

7. Magnetic element with thermally-assisted magnetic field or spin-transfer writing according to claim 6, **characterized in that** the metal coming into the composition of the metal oxide or nitride making up the layer or layers (48) is chosen in the group including tantalum, aluminum, magnesium, zirconium, zinc and cobalt.

## Patentansprüche

1. Magnetisches Element mit thermisch assistiertem magnetischen Feld- oder Spintransferschreiben, einschliessend:
• eine Referenzschicht (43) mit einer statischen Magnetisierung;
• eine magnetische Speicherschicht (40) mit einer antiferromagnetischen Schicht (41) austauschgekoppelt ist, wobei die Magnetisierungsrichtung der Speicherschicht (40) variieren kann, wenn besagtes Element zu einer Temperatur mindestens höher als die Blocktemperatur von der antiferromagnetischen Schicht (41) geheizt wird;
• eine Isolations- oder Halbleiterschicht (42) oder eine Schicht mit einem begrenztem Stromweg, bereitgestellt zwischen der Referenzschicht und der Speichersicht;
**gekennzeichnet dadurch, dass**
das magnetische Element zudem mindestens eine dünne, elektrisch widerstandfähige Schicht (48) umfasst, die in mindestens einer der Schichten abgelagert ist, umfassend die magnetische Referenzschicht (43), die magnetische Speicherschicht (40), die antiferromagnetische Austauschschicht (41) und/oder ein Interface, das zwischen der Speicherschicht (40) und der antiferromagnetischen Schicht (41) abgelagert ist, besagte mindestens eine elektrisch widerstandfähige Schicht (48) erlaubt es, das magnetische Element zu heizen.

2. Das magnetische Element gemäss Anspruch 1, wobei besagte magnetische Referenzschicht (43) an eine antiferromagnetische Schicht (44) gekoppelt ist, und wobei besagte mindestens eine dünne Schicht (48) in der antiferromagnetischen Schicht (44) und/oder in dem Interface zwischen der Referenzschicht (43) und der antiferromagnetischen Schicht (44) umfasst ist.

3. Magnetisches Element mit thermisch assistiertem magnetischen Feld- oder Spintransferschreiben gemäss einem der Ansprüche 1 oder 2, **gekennzeichnet dadurch, dass** die Dicke der dünnen Sicht oder Schichten (48) einen elektrischen Widerstand von ungefähr 10 Mal geringer als der interne Widerstand die Tunnelsperre (42) hat.

4. Magnetisches Element mit thermisch assistiertem magnetischen Feld- oder Spintransferschreiben gemäss einem der Ansprüche 1 bis 3, **gekennzeichnet dadurch, dass** die Dicke der dünnen Sicht oder Schichten (48) mindestens ein Nanometer ist.

5. Magnetisches Element mit thermisch assistiertem magnetischen Feld- oder Spintransferschreiben gemäss einem der Ansprüche 1 bis 5, **gekennzeichnet dadurch, dass** die Schicht oder Schichten (48) mit hohem elektrischen Widerstand unzusammenhängend sind.

6. Magnetisches Element mit thermisch assistiertem magnetischen Feld- oder Spintransferschreiben gemäss einem der Ansprüche 1 bis 5, **gekennzeichnet dadurch, dass** die Schicht oder Schichten (48) mit hohem elektrischen Widerstand auf Metalloxid oder Metallnitrid bestehen.

7. Magnetisches Element mit thermisch assistiertem magnetischen Feld- oder Spintransferschreiben gemäss Anspruch 6, **gekennzeichnet, dadurch dass** das Metall, das mit dem Metalloxid oder -nitrid in Zusammensetzung kommt, um die Schicht oder die Schichten (48) zu bilden, aus der Gruppe kommt, die Tantal, Aluminium, Magnesium, Zirkonium, Zink und Kobalt einschliesst.
